# EUROPEAN PATENT APPLICATION

(11) **EP 4 844 294 A2**
(43) Date of publication of application: **25.11.2026**
(21) Application number: 26169990.4
(22) Date of filing: 31.03.2026
(51) Int. Cl.: F24F 8/30, F24F 7/00, F24F 7/007, F28F 5/00, H05H 1/24, H05H 1/48, H05K 7/20

(54) **PLASMA GENERATOR, CONDENSER HEAT DISSIPATION DEVICE AND REFRIGERATION APPARATUS**

(30) Priority: 20.05.2025 CN 202510650943; 02.09.2025 CN 202511245069
(71) Applicant: Luo, Xing, Shenzhen (CN); Zhang, Xiaojun, Beizhen City, Jinzhou City, Liaoning Province (CN)
(72) Inventor: Luo, Xing, Shenzhen (CN)
(74) Representative: Petraz, Gilberto Luigi

(57) **Abstract**

The present invention discloses a plasma generator, a condenser heat dissipation device and a refrigeration apparatus. Through the cooperation of electrode modules and collector modules to ionize air, an ionic wind is produced, the ionization structures are respectively integrated into the plasma generator and the condenser heat dissipation device, and are cooperatively mounted on the refrigeration apparatus to form a bladeless heat dissipation structure, so as to effectively reduce the volume of the refrigeration apparatus; the ionic wind directly acts on the condenser to disrupt the laminar boundary layer, reduce the flow resistance, greatly improve the heat dissipation efficiency, and take into account the requirements of miniaturization and high-efficiency heat dissipation of the apparatus.

## Description

### Technical Field

The present invention relates to the technical field of refrigeration apparatus, particularly to a plasma generator, a condenser heat dissipation device and a refrigeration apparatus.

### Background Art

Refrigeration apparatuses are widely used in data center and other systems at present. Most of the existing refrigeration apparatuses employ bladed fans for external heat exchange. The large volume of a single fan makes the internal layout of refrigeration apparatus difficult and the overall volume is difficult to compress. Moreover, the upper limit of air velocity is relatively low, which makes it difficult to further improve the heat dissipation capacity of refrigeration apparatus; the refrigeration apparatuses are difficult to be placed near the residential areas because of the large rotation inertia, long speed regulation time and large rotation noise.

### Summary of the Invention

It is an objective of the present invention to overcome the deficiencies of the prior art and to provide a plasma generator, a condenser heat dissipation device and a refrigeration apparatus.

In order to achieve the above-mentioned objective, the present invention adopts the following technical solutions:

In a first aspect, the present invention provides a plasma generator, including an insulating support, electromagnetic shielding members and an ionization unit disposed on the insulating support, wherein the electromagnetic shielding members and the insulating support are combined to form an electromagnetic shielding cavity, the ionization unit is disposed in the electromagnetic shielding cavity, the ionization unit includes at least one set of collector modules and electrode modules arranged oppositely and at intervals, and the collector modules cooperate with the electrode modules to ionize air and produce a flowing airflow.

In a second aspect, the present invention further provides a condenser heat dissipation device, including an electrode modules, condensing modules and power supply modules, wherein the electrode modules and the condensing modules are arranged at intervals, the electrode modules cooperate with the condensing modules to ionize air and produce a flowing airflow, the electrode modules include an insulating substrate, a plurality of needle-shaped electrodes facing the condensing modules are disposed on one side of the insulating substrate close to the condensing modules, the condensing modules are provided with collector modules, negative electrodes of the electrode modules are connected to the needle-shaped electrodes, and positive electrodes of the electrode modules are connected to the collector modules.

In a third aspect, the present invention further provides a refrigeration apparatus, the refrigeration apparatus includes an apparatus main body and the above-mentioned plasma generator, the plasma generator is disposed in a gas circulation air duct between an air inlet and an air outlet of the apparatus main body, the plasma generator causes the air in the gas circulation air duct to flow from the air inlet of the apparatus main body to the air outlet of the apparatus main body; and/or,

the refrigeration apparatus includes fans and the above-mentioned condenser heat dissipation device, the fans are arranged at intervals on one side of the condenser heat dissipation device close to the air outlet of the refrigeration apparatus.

The beneficial effects of the present invention compared to the prior art are: through the cooperation of electrode modules and collector modules to ionize air, an ionic wind is produced, the ionization structures are integrated into the plasma generator to form a bladeless ionic wind generating device, replacing the traditional bladed fan and cooperating with the condenser heat dissipation device to act on the refrigeration apparatus. The characteristics of the ionic wind without a rotating component greatly reduce the volume of the heat dissipation structure and optimize the internal layout of the refrigeration apparatus. At the same time, the ionic wind can enhance the heat dissipation capacity by raising the upper limit of the air velocity, and also can disrupt the boundary layer on the surface of the condenser and reduce the flow resistance to further improve the heat exchange efficiency, without the problems of the slow speed regulation and large noise caused by the rotation inertia. In terms of structure and principle, the technical problems of large volume and poor heat dissipation capacity of traditional refrigeration apparatus are fundamentally solved, and finally the effects of miniaturization of refrigeration apparatus and improvement of heat dissipation efficiency are achieved.

The above description is merely an overview of the technical solution of the present invention, to enable a clearer understanding of the technical means of the present invention, the embodiments may be implemented in accordance with the contents of the specification. Furthermore, in order to make the aforementioned and other objectives, features, and advantages of the present invention more readily apparent and easily understood, specific preferred embodiments are provided below for detailed explanation.

### Brief Description of the Drawings

In order to explain the technical solutions of the embodiments of the present invention more clearly, a brief description will be given below to the drawings which are used in the description of the embodiments; it is obvious that the drawings in the description below are some embodiments of the present invention, and it would have been obvious for a person of ordinary skill in the art to obtain other drawings according to these drawings without involving any inventive effort.
FIG. 1 is a schematic diagram of a structure of a plasma generator provided by a specific embodiment of the present invention;
FIG. 2 is a schematic diagram of a structure of a refrigeration apparatus provided by a specific embodiment of the present invention;
FIG. 3 is a first exploded view of a refrigeration apparatus provided by a specific embodiment of the present invention;
FIG. 4 is a second exploded view of a refrigeration apparatus provided by a specific embodiment of the present invention;
FIG. 5 is a schematic diagram of a combination of collector modules and electrode modules in a plasma generator provided by a specific embodiment of the present invention;
FIG. 6 is a system architecture view of a refrigeration apparatus provided by a specific embodiment of the present invention;
FIG. 7 is a flow chart of a heat dissipation method of a refrigeration apparatus provided by a specific embodiment of the present invention;
FIG. 8 is an exploded view of a condenser heat dissipation device provided by a first embodiment of the present invention;
FIG. 9 is an exploded view of a condenser heat dissipation device provided by a second embodiment of the present invention;
FIG. 10 is an exploded view of a condenser heat dissipation device provided by a third embodiment of the present invention;
FIG. 11 is an exploded view of a condenser heat dissipation device provided by a fourth embodiment of the present invention;
FIG. 12 is a top view of a condenser heat dissipation device provided by an embodiment of the present invention;
FIG. 13 is a schematic diagram of a structure of waterproof sleeves of a refrigeration apparatus provided by an embodiment of the present invention;
FIG. 14 is an enlarged view of a portion A of FIG. 13;
FIG. 15 is a schematic diagram of a structure of waterproof sleeves of a refrigeration apparatus provided by another embodiment of the present invention;
FIG. 16 is an enlarged view of a portion B of FIG. 15;
FIG. 17 is a schematic diagram of a structure of waterproof sleeves of a refrigeration apparatus provided by yet another embodiment of the present invention;
FIG. 18 is an enlarged view of a portion C of FIG. 17;
FIG. 19 is a schematic diagram of a structure of FIG. 17 from a back side perspective;
FIG. 20 is an enlarged view of a portion D of FIG. 19;
FIG. 21 is a schematic diagram of a structure of waterproof louvers of a refrigeration apparatus provided by an embodiment of the present invention;
FIG. 22 is a schematic diagram of a mechanism of a single waterproof sleeve of a refrigeration apparatus provided by an embodiment of the present invention; and
FIG. 23 is a schematic diagram of a mechanism of a single waterproof sleeve of a refrigeration apparatus provided by another embodiment of the present invention;

### Reference numerals:

1, plasma generator; 11, main frame; 12, first outer frame; 121, electromagnetic shielding member; 13, first inner frame; 14, first mounting frame; 141, collector module; 15, second mounting frame; 151, electrode module; 1511, needle-shaped electrode; 1512, insulating substrate; 1513, waterproof sleeve; 1514, vent hole; 1515, electrode insertion hole; 16, second outer frame; 161, insulating protective member; 17, second inner frame; 18, spacing adjustment assembly; 2, apparatus main body; 21, air inlet; 3, air inlet guard; 4, condensing module; 41, condensing pipeline; 42, heat dissipation fin; 43, equipotential bonding plate; 44, metal grid; 441, load-bearing strip; 45, support frame; 5, fan; 6, waterproof louver.

### Detailed Description of the Invention

The technical solution of the present invention will be described clearly and completely hereinafter in combination with specific embodiments of the present invention, obviously, the embodiments described are merely a portion of the embodiments of the present invention, rather than all of them.

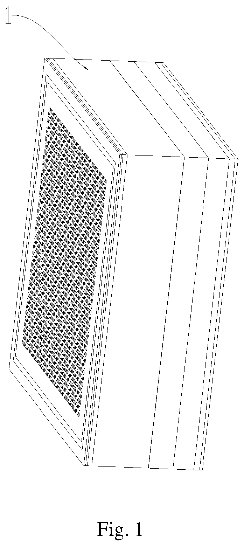

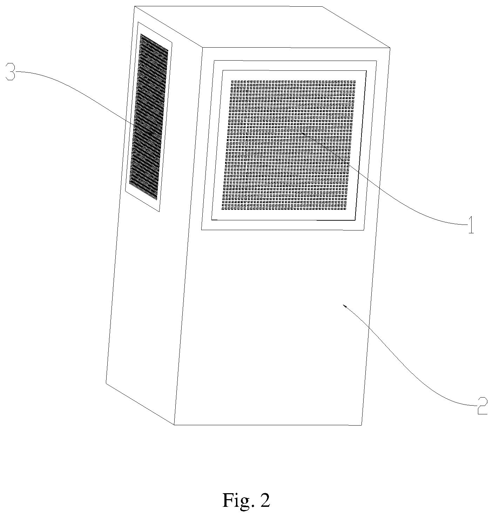

As shown in FIGS. 1 to 5, an embodiment of the present invention provides a plasma generator 1, including an insulating support, electromagnetic shielding members 121 and an ionization unit disposed on the insulating support, wherein the electromagnetic shielding members 121 and the insulating support are combined to form an electromagnetic shielding cavity, the ionization unit is disposed in the electromagnetic shielding cavity, the ionization unit includes at least one set of collector modules 141 and electrode modules 151 arranged oppositely and at intervals, and the collector modules 141 cooperate with the electrode modules 151 to ionize air and produce a flowing airflow.

In the present invention, an ionization unit including collector modules 141 and electrode modules 151 is disposed on the insulating support, and the two are arranged oppositely and at intervals and cooperate to ionize air and produce a flowing airflow. The ionization unit is an ionic wind generating structure without a rotating component, the volume of a heat dissipation component is greatly reduced compared with a traditional bladed fan, the difficulty of internal layout of a refrigeration apparatus is reduced, and the effective compression of the overall volume of the apparatus is achieved; at the same time, the airflow produced by the ionization of the structure has no mechanical restriction of an upper limit of the air velocity, and the output intensity of the airflow can be significantly increased, thereby effectively improving the heat dissipation capacity of the refrigeration apparatus. In terms of the structural design and the principle of airflow generation, the technical problems of large volume and poor heat dissipation capacity of the existing refrigeration apparatus are solved, and finally the effects of miniaturization of heat dissipation components, optimization of internal layout and significant improvement of heat dissipation capacity of the refrigeration apparatus are achieved.

In addition, at present, the refrigeration apparatus based on the plasma wind is prone to causing electromagnetic interference to the electronic apparatuses arranged around it during use, which in turn easily leads to safety accidents. The present invention utilizes an electromagnetic shielding cavity formed by electromagnetic shielding members and an insulating support to effectively prevent electromagnetic interference caused to external apparatuses or components during the operation of the ionization unit, thereby enhancing the safety of use.

As the basic structural component of the plasma generator 1, the insulating support plays the role of supporting and fixing other assemblies, and at the same time, due to its insulating characteristics, it may prevent current leakage and ensure the safety of use. Specifically, the insulating support may be made of plastic or other insulating material, which has excellent insulating properties and mechanical strength. Aluminum oxide ceramic may also be selected as the material of the insulating support, which likewise has excellent insulation property and high hardness.

The electromagnetic shielding members 121 may adopt metal shields, such as metal meshes of copper or aluminum or steel. The ionization unit is disposed in the electromagnetic shielding cavity, and during operation, the electromagnetic shielding cavity can effectively isolate the electromagnetic wave produced by the ionization unit and prevent the electromagnetic interference caused by the ionization unit to external apparatuses or components; at the same time, the electromagnetic shielding cavity can also resist the interference of external electromagnetic wave to the ionization unit, and ensure its stable operation.

It should be noted that since the electromagnetic shielding only shields electromagnetic interference, the electromagnetic shielding members have at least structures such as air passing holes or air passing channels to allow air to flow through smoothly.

The electrode modules 151 include an insulating substrate, the material of the insulating substrate may be selected from glass fiber epoxy resin, aluminum oxide ceramic, etc.; a plurality of needle-shaped electrodes 1511 are disposed on one side of the insulating substrate close to the collector modules 141, and the needle-shaped electrodes 1511 may adopt stainless steel material and be plated with zinc or sprayed with a Teflon coating so as to improve the corrosion resistance and hydrophobicity. The material of needle-shaped electrodes 1511 may also be selected from tungsten, copper and titanium alloy, etc. Each of the needle-shaped electrodes 1511 is connected by a wire on an insulating base or an etched copper foil or a metal grid or the like to form a matrix of a plurality of needle-shaped electrodes 1511.

The collector modules 141 include a collector electrode substrate, a plurality of metal meshes are disposed on the collector electrode substrate, and the design of the metal mesh holes facilitates the collection of ions and the passage of airflow, and the stainless steel may be selected as the material of the collector electrode substrate. In addition, besides the metal mesh, the structure of the collector electrode substrate may also adopt a specially-made flat plate flow guiding structure.

When a high voltage is applied to the electrode modules 151 and the collector modules 141, the needle-shaped electrodes 1511 ionize the air, so that some molecules or atoms in the air lose electrons and become ions, and under the action of an electric field, the ions move towards the collector modules 141 and collide with neutral air molecules, thereby producing a flowing airflow.

The present invention can effectively prevent electromagnetic interference, improve the safety and stability of the plasma generator 1 in use, reduce the influence on peripheral electronic apparatuses, and ensure the normal operation of the whole refrigeration apparatus system.

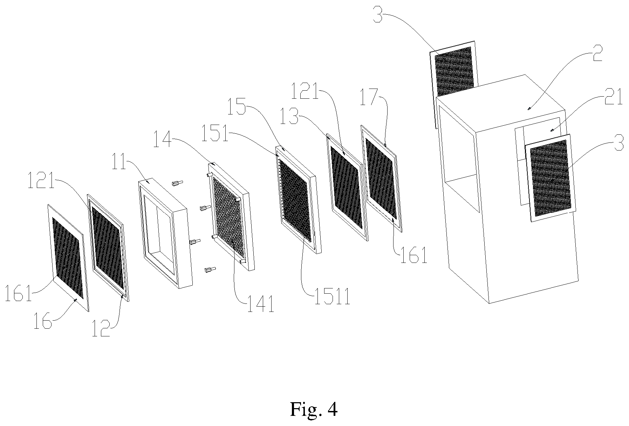

As shown in FIG. 4, the insulating support includes a main frame 11, a first outer frame 12 and a first inner frame 13, the first outer frame 12 is disposed outside the main frame 11, the first inner frame 13 is disposed inside the main frame 11, the first outer frame 12 and the first inner frame 13 are both provided with electromagnetic shielding members 121, and the collector modules 141 and the electrode modules 151 are disposed between the first outer frame 12 and the first inner frame 13.

The main frame 11 may be made of plastic or other insulating material boards through machining processes such as cutting, punching, etc., and is cut into a suitable rectangular frame shape, and is punched at four corners of the frame for subsequent connection and fixation with other frames. The thickness of the main frame 11 may be selected according to the actual load bearing requirements.

The first outer frame 12 is disposed outside the main frame 11, and the main function thereof is to provide a carrier for mounting the electromagnetic shielding members 121 with the main frame 11 and the first inner frame 13. The first outer frame 12 is adapted in size to the main frame 11, and can fit tightly to the outside of the main frame 11. In the manufacturing process, grooves may be formed on a side surface of the first outer frame 12 facing the main frame 11 for inserting the electromagnetic shielding members 121 therein.

The first inner frame 13 is disposed inside the main frame 11, and corresponds to the first outer frame 12, and together enclose and form an internal space. The structure and manufacturing process of the first inner frame 13 are similar to those of the first outer frame 12, and plastic or other insulating materials are also adopted. When being mounted, the first inner frame 13 and the main frame 11 are connected by bolts, and the spacings of the bolts may be set according to the size of the frame, so as to ensure the stability of the connection. At the same time, a structure for mounting the electromagnetic shielding members 121 is also disposed on the first inner frame 13, and cooperates with the electromagnetic shielding members 121 on the first outer frame 12 to form a complete electromagnetic shielding layer.

When the ionization unit is in operation, the electromagnetic wave will be produced, if not shielded, the electromagnetic wave may cause interference to the surrounding electronic apparatuses. At the same time, the external electromagnetic wave may influence the normal operation of ionization unit. The electromagnetic wave can be effectively isolated by the electromagnetic shielding cavity formed by the electromagnetic shielding members 121 on the first outer frame 12 and the first inner frame 13. According to the principle of electromagnetic shielding, when the electromagnetic wave encounters the metal shielding member, an induced current will be produced on the metal surface, and the reverse magnetic field produced by the induced current will cancel out part of the incident electromagnetic wave, so as to achieve the shielding effect.

As shown in FIG. 4, the insulating support further includes a first mounting frame 14 and a second mounting frame 15, the first mounting frame 14 and the second mounting frame 15 are disposed between the main frame 11 and the first inner frame 13, and the first mounting frame 14 is disposed close to the main frame 11, the collector modules 141 are disposed in the first mounting frame 14, and the electrode modules 151 are disposed in the second mounting frame 15.

The first mounting frame 14 and the second mounting frame 15 may be formed by an injection molding or cutting process adopting the same plastic or other insulating material as the main body of the insulating support. When being mounted, the first mounting frame 14 and the second mounting frame 15 are disposed between the main frame 11 and the first inner frame 13. The mounting grooves or mounting holes are preset on the main frame 11 and the first inner frame 13, and then the first mounting frame 14 and the second mounting frame 15 are inserted into the mounting grooves or fixed by means of screws passing through the mounting holes. The second mounting frame 15 is mounted in a similar manner, ensuring accurate relative positioning of the two mounting frames between the main frame 11 and the first inner frame 13 by precise mounting positioning.

The first mounting frame 14 is provided close to the main frame 11, and the internal structure thereof is designed according to the shapes and sizes of the collector modules 141. For example, if the collector modules 141 are of rectangular flat plate structures, rectangular grooves matching the shapes of the collector modules 141 can be provided inside the first mounting frame 14, the depths of the grooves are slightly greater than the thicknesses of the collector modules 141, and rubber materials are provided in the grooves, so that the collector modules 141 can be smoothly inserted and fixed, and at the same time, a shock-absorbing effect can be achieved. After being placed in the grooves of the first mounting frame 14, the collector modules 141 may be fixed by means of a snap, screw or glue, etc.

The second mounting frame 15 is used for mounting the electrode modules 151, and the design thereof also takes into account the structural characteristics of the electrode modules 151. The rectangular grooves matching the shapes of the electrode modules 151 can be provided inside the second mounting frame 15, the depths of the grooves are slightly greater than the thicknesses of the electrode modules 151, and rubber materials are provided in the grooves, so that the electrode modules 151 can be smoothly inserted and fixed, and at the same time, a shock-absorbing effect can be achieved. After being placed in the grooves of the second mounting frame 15, the electrode modules 151 may be fixed by means of a snap, screw or glue, etc.

By providing the first mounting frame 14 and the second mounting frame 15, an orderly mounting and a precise positioning of the collector modules 141 and the electrode modules 151 are achieved. This layered mounting structure avoids mutual interference between the two modules in the mounting process, and improves the mounting efficiency and accuracy. At the same time, the independent mounting frame provides a stable support for the collector modules 141 and the electrode modules 151, reduces the displacement or loosening caused by vibration and other factors during the operation of the modules, and ensures the stability and reliability of the operation of the ionization unit. In addition, the provision of the mounting frame is also beneficial to separate maintenance and replacement of the collector modules 141 and the electrode modules 151, and when one of the modules fails, the entire ionization unit does not need to be dismantled, and only the corresponding mounting frame needs to be dismantled for maintenance or replacement, which reduces the maintenance cost and difficulty.

It should be noted that, in the same plasma generator 1, multiple sets of electrode modules 151 and collector modules 141 may be designed to achieve multi-stage ionization by way of superposition, so as to effectively raise the air velocity without increasing the electrode voltage.

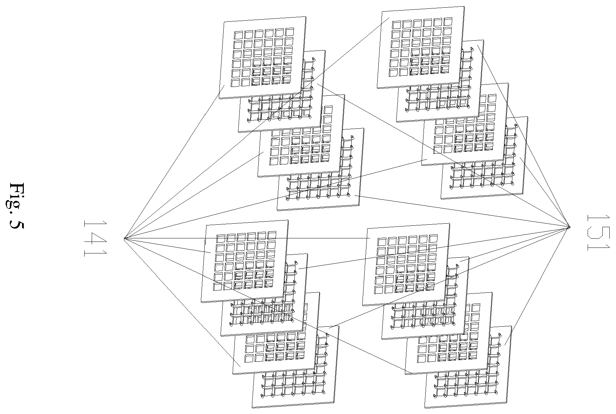

It should also be noted that the multiple sets of electrode modules 151 and collector modules 141 may be manufactured in the form of a segmented array, i. e., as shown in FIG. 5, so designed to facilitate low-cost replacement and maintenance in the event of a single-point abnormality, and also to ensure that the normal operation of other modules remains uninfluenced even if some of the electrode modules 151 or collector modules 141 are damaged.

As shown in FIG. 4, the plasma generator 1 further includes a spacing adjustment assembly 18, the spacing adjustment assembly 18 is used for adjusting spacings between the collector modules 141 and the electrode modules 151, the spacing adjustment assembly 18 includes a driving member, and the driving member is used for driving ones of the collector modules 141 and the electrode modules 151 to move towards or away from the others.

The driving member may be an electric motor, a hydraulic cylinder, or a pneumatic cylinder, etc. The transmission methods may be a screw and nut transmission, a rack and pinion transmission or a synchronous belt transmission.

Taking a combination of an electric motor, a screw and a nut as the driving member as an example, a fixing support is preset on the main frame 11 of the insulating support, the electric motor is fixed on the fixing support, the nut is fixed on the collector modules 141, and one end of the screw is fixedly connected to the output shaft of the electric motor, and the other end is inserted in the nut.

When it is necessary to adjust the spacings between the collector modules 141 and the electrode modules 151, a corresponding electrical signal is sent to the electric motor to drive the electric motor to rotate. The electric motor converts the rotational motion of the electric motor to the linear motion of the nut through the screw. The forward or backward movement of the nut drives the collector modules 141 on the first mounting frame 14 connected thereto relatively close to or away from the electrode modules 151, thereby changing the spacing between the two.

The provision of the spacing adjustment assembly 18 enables the plasma generator 1 to flexibly adjust the spacings between the collector modules 141 and the electrode modules 151 according to actual operating requirements. By adjusting the voltages and spacings between the collector modules 141 and the electrode modules 151 under different loads of refrigeration apparatuses, the minimum power consumption can be achieved under the condition of meeting the air volume requirements. For example, when the refrigeration apparatus is in a low load operating state, the voltages between the collector modules 141 and the electrode modules 151 may be reduced, and at the same time, the spacings between the collector modules 141 and the electrode modules 151 may be appropriately reduced to reduce power consumption; however, in high load operation, the voltages between the collector modules 141 and the electrode modules 151 are increased, and at the same time, the spacings between the collector modules 141 and the electrode modules 151 are controlled to be slightly greater than the electrical gap which needs to be maintained under the current voltage, so as to enhance the heat dissipation effect while controlling the power consumption to be at a minimum.

As shown in FIG. 4, the plasma generator 1 further includes insulating protective members 161, the insulating support further includes a second outer frame 16 and a second inner frame 17, the second outer frame 16 is located outside the first outer frame 12, the second inner frame 17 is located inside the first inner frame 13, and the second outer frame 16 and the second inner frame 17 are both provided with the insulating protective members 161.

Plastic materials may be selected for insulating protective members 161 in the form of a mesh structure, providing excellent insulating properties and strength. The design of mesh structure can not only ensure the requirements of ventilation and heat dissipation, but also prevent a person from directly being in contact with the internal high voltage components, and avoid insects and other foreign objects entering the interior of the apparatus. For example, the mesh diameters of the insulating protective members 161 may be set as desired according to the use scenario, so as to block the entry of fingers or metal wires without influencing the air circulation. By the same reasoning, the structural designs of the second outer frame 16 and the second inner frame 17 are consistent.

When the insulating protective members 161 are mounted, with regard to the second outer frame 16 and the second inner frame 17 adopting a snap-fit groove structure, the edges of the insulating protective members 161 are aligned with the snap-fit grooves first, and then the insulating protective members 161 are inserted into the snap-fit grooves by gently pressing. In order to further enhance the stability of the mounting, a small amount of insulating sealant may be applied to the contact site of the insulating protective members 161 with the snap-fit grooves so as to prevent the insulating protective members 161 from being loosened or displaced. Of course, a mounting hole method may also be adopted, and the insulating screws are used to fix the insulating protective members 161 on the frame.

The provision of the second outer frame 16, the second inner frame 17 and the insulating protective members 161 forms a multi-layer insulating protective barrier. Firstly, the operator is effectively prevented from accidentally being in contact with the high voltage components inside the plasma generator 1, the risk of electric shock is greatly reduced, and the safety of the person is ensured. Secondly, the foreign objects such as insects are blocked from entering the interior of the apparatus, and the failures such as short circuit and component damage caused by the foreign objects are avoided, so that the reliability and stability of the operation of the plasma generator 1 are improved.

As shown in FIGS. 1 to 6, an embodiment of the present invention also provides a refrigeration apparatus, including an apparatus main body 2 and the above-mentioned plasma generator 1, the plasma generator 1 is disposed in a gas circulation air duct between an air inlet 21 and an air outlet of the apparatus main body 2, and the plasma generator 1 causes the air in the gas circulation air duct to flow from the air inlet 21 of the apparatus main body 2 to the air outlet of the apparatus main body 2.

Refrigeration apparatuses may be classified into common types such as liquid coolers and air conditioners, and contain core refrigeration components such as compressors and condensers inside. Taking an air conditioner as an example, the apparatus main body 2 is generally composed of a shell, an internal refrigeration circulation pipeline, an electric control system, etc. The plasma generator 1 is mounted in a gas circulation air duct between an air inlet 21 and an air outlet of the apparatus main body 2, and the specific mounting position needs to be planned according to the internal space structure of the apparatus main body 2.

In the actual mounting process, it is necessary to firstly reserve a mounting interface at the position corresponding to the air duct of the shell of the apparatus main body 2, and the shape of the interface is adapted to the shape of the plasma generator 1, for example, a rectangular interface matches a rectangular plasma generator 1. Taking the outdoor unit of a split-type air conditioner as an example, a rectangular opening of the same size as that of the plasma generator 1 is disposed on the shell side of the outdoor unit, a mounting flange is provided on the edge of the opening, and an insulating support of the plasma generator 1 is fixedly connected to the mounting flange by bolts, so as to ensure a firm mounting and good sealing. At the same time, in order to reduce the influence of vibration generated by the operation of the plasma generator 1 on the apparatus main body 2, a rubber shock-absorbing pad may be mounted between the insulating support and the mounting flange, so as to play the role of buffering and shock absorption.

When the plasma generator 1 is applied to the gas circulation air duct of refrigeration apparatus, it has many significant advantages compared with the traditional heat dissipation method using the bladed fans. Firstly, the plasma generator 1 has a smaller volume without a rotating component, which can effectively optimize the internal space layout of the refrigeration apparatus, make the overall volume of the apparatus more compact, and facilitate the mounting and transportation. Secondly, the plasma generator 1 may produce a higher upper limit of airflow velocity by superposing the layers and raising the voltage, which can quickly take away the heat from the condenser, significantly improve the heat dissipation capacity of the refrigeration apparatus, and ensure the stable operation of the refrigeration apparatus under high load operating conditions. Moreover, due to the absence of rotation inertia, the plasma generator 1 has a rapid speed adjustment response, enabling immediate and fast response and adjustment of air velocity according to the real-time heat dissipation requirements of the refrigeration apparatus, significantly reducing speed adjustment time compared to traditional fans. In addition, when the plasma generator 1 is in operation, there is no friction of rotating components, and the noise is extremely low, making the refrigeration apparatus suitable for places with strict noise requirements such as residential areas.

It should be noted that the plasma generator 1 may not only be mounted in the gas circulation air duct between the air inlet 21 and the air outlet of the apparatus main body 2, but may also be mounted at a corner of the gas circulation air duct or on a branch air duct according to the features of the internal structure of the apparatus main body 2.

It should be understood that on the basis of retaining the plasma generator **1,** it may be used simultaneously in conjunction with traditional heat dissipating fans. When the refrigeration apparatus is in a low load operation, only the plasma generator 1 is activated for heat dissipation; when the apparatus is in a high load operating state, the plasma generator 1 works in cooperation with the heat dissipation fan to further enhance the heat dissipation effect. For example, in an industrial water chilling unit in a high temperature environment, the plasma generator 1 and the heat dissipation fan are simultaneously activated during a high temperature period in summer to ensure stable cooling of the water chilling unit.

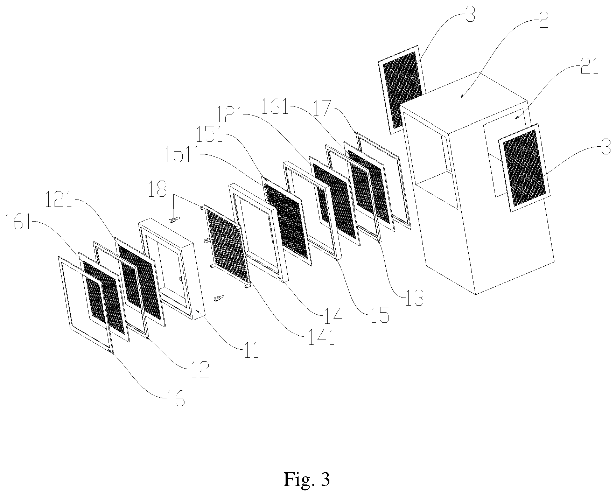

As shown in FIG. 3, an air inlet guard 3 is provided at an air inlet 21 of the apparatus main body 2. It is mainly used to protect the air inlet 21 of the refrigeration apparatus, to avoid foreign objects entering the interior of the apparatus, and to influence the long-term stable operation of the apparatus. In terms of structural design, the air inlet guard 3 may adopt a metal mesh grid structure, such as a stainless steel mesh grid, and a dust guard is selected according to the use environment. The mesh size of the mesh grid shall be designed according to the actual use environment.

It should be noted that, in a rainy area, a rain guard may be mounted above the air inlet guard 3. The rain guard may be made of arc-shaped plastic or metal plates, and is fixed above the air inlet guard 3 through a support. The length and width of the rain guard should be greater than that of the air inlet guard 3 to ensure that rainwater can be completely shielded. The stainless steel material may be selected for the support, and the support is fixed to the rain guard and the apparatus main body 2 by means of welding or bolting. For example, the rain guard is mounted on the outdoor refrigeration apparatus in the southern coastal area, rainwater can be effectively prevented from directly entering the air inlet 21, and the influence of apparatus corrosion caused by rainwater can be prevented.

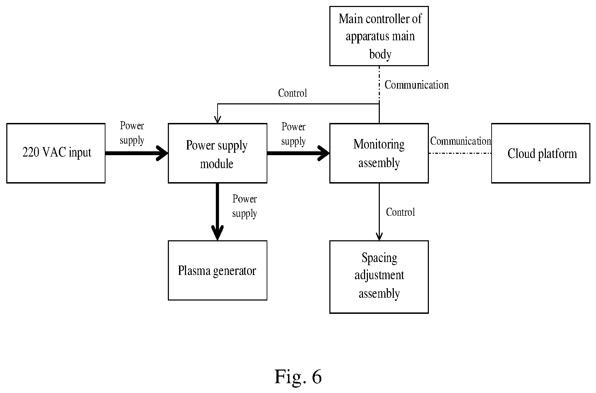

As shown in FIG. 6, the apparatus main body 2 further includes a monitoring assembly and a cloud platform; the monitoring assembly includes a sensor and a controller; the controller is connected to the sensor, the power supply modules, the cloud platform, and the main controller of the apparatus main body 2; the sensor monitors the ionization unit; and the power supply modules supply power to the monitoring assembly and the plasma generator.

As the sensing unit of the monitoring assembly, the sensor is used to collect the key data of operation of the ionization unit and the apparatus in real time. For the ionization unit, various types of sensors may be deployed, specifically, a current sensor, a voltage sensor, an infrared sensor, an ultrasonic sensor, a thermal imaging camera, an air velocity sensor, a temperature sensor, a humidity sensor, and a thermistor, etc.

A current sensor and a voltage sensor are generally integrated in the power supply modules of the apparatus main body 2 for monitoring current and voltage parameters during the operation of the electrode modules 151 and the collector modules 141. For example, a Hall current sensor or a shunt is adopted, which is enclosed inside the power supply modules, and is connected to the controller of the apparatus main body 2 through a signal line, the magnitude of the current in the circuit can be precisely detected and data can be transmitted to the controller of the apparatus main body 2.

An infrared sensor, an ultrasonic sensor, a thermal imaging camera, an air velocity sensor, a temperature sensor, and a humidity sensor are mounted on the insulating support. The thermistor is directly mounted on the electrode to monitor the electrode temperature, for example, an NTC (negative temperature coefficient) thermistor is adopted, its resistance value decreases as temperature increases. The electrode temperature information may be accurately acquired by measuring the variation of resistance value.

The controller is composed of a MCU (microcontroller unit) and its control circuit, and communicates with a main controller of the apparatus main body 2. The MCU, as the core control component, for example, an ARM series microprocessor is adopted, has powerful data processing and control capabilities. The controller is connected to each sensor through a data line, and receives data collected by the sensor; at the same time, the controller is connected the cloud platform, the power supply modules and the main controller of the apparatus main body 2 through a communication line and a wireless communication module. For example, data interaction is performed with the cloud platform through the 4G module, and communication is performed with the power supply modules and the main controller of the apparatus main body 2 through the CAN or 485 bus, so as to achieve rapid data transmission and accurate instruction reception.

When the refrigeration apparatus is in operation, the sensor continues to collect data. For example, the current sensor monitors the current between the electrodes, to determine whether there is an arcing phenomenon; the infrared sensor detects the reflectivity of the electrode surface, to assess electrode dust accumulation situation. These data are transmitted to the controller in real time. The controller analyzes and processes the received data. For example, when the controller receives an abnormal data of the current sensor and determines that an arcing may occur between the electrodes, a control measure is immediately taken, such as controlling the power supply modules to reduce the voltages between the electrodes and the collector electrodes, and at the same time, the alarm information is uploaded to the main controller of the apparatus main body 2 and the cloud platform through a communication line. In addition, in the normal operation of the system, after receiving the data uploaded by the refrigeration apparatus, the cloud platform will compare the data with the real-time operating data and variation trend of the data, historical operating data and variation trend of the data of other refrigeration apparatus and analyze the dispersion degree. For example, a big data analytics algorithm is adopted to perform clustering analysis on the operating data and variation trend of the data of the same model of refrigeration apparatus under the same operating condition for the same duration, and if it is found that the data or variation trend of a certain apparatus deviates significantly from the data of other systems, the cloud platform will issue early warning, generate early warning information and send same to operation and maintenance personnel, and prompt them to inspect and confirm the risks.

The monitoring assembly monitors the operating state of the ionization unit and the apparatus in real time through a variety of sensors, enabling effective surveillance of risks such as arcing between electrodes, electrode dust accumulation, electrode wear, and electrode overheating, so as to promptly detect potential failure hazards and prevent the escalation of apparatus failures. According to the sensor feedback data and the requirements of the main controller of the apparatus main body 2, the controller controls the power supply modules to adjust the plasma generator 1 in real time, such as adjusting the parameters of the electrode and collector electrode power supply, the voltage level, the voltage direction, the voltage duty cycle and the spacings between the electrodes and collector electrodes, ensuring that the system can effectively meet the heat dissipation requirements under different operating conditions, and improve the stability and reliability of the apparatus operation. The introduction of cloud platform achieves the centralized management and analysis of multi-apparatus data. Through the data comparison and early warning mechanism, the abnormal apparatus can be found in advance, the maintenance and treatment can be carried out timely by the operation and maintenance personnel, the failure rate of apparatus can be reduced, the downtime can be reduced, and the overall operation and maintenance efficiency and service life of the apparatus can be improved.

As shown in FIG. 6, after the refrigeration apparatus is activated, the power supply modules converts the external 220 V mains power into a low voltage direct current, one portion is supplied to the monitoring module, and the other portion is connected to the electrode modules 151 and the collector modules 141 of the plasma generator 1 after being boosted to a plurality of thousand volts via the high voltage generating module. The needle-shaped electrodes 1511 of the electrode modules 151 ionize air under the action of a high voltage to produce ions, and the ions move towards the collector modules 141 under the action of an electric field force, collide with neutral air molecules, and propel the air molecules to form an airflow.

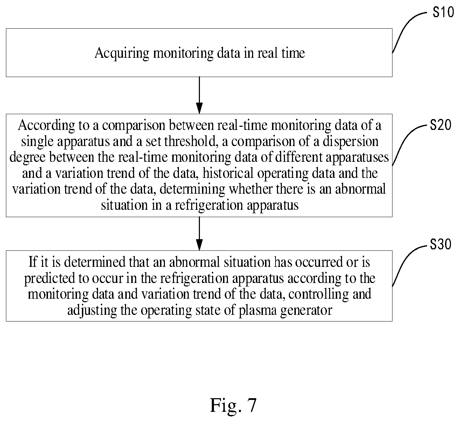

As shown in FIG. 7, an embodiment of the present invention further provides a heat dissipation early warning and control method based on the above-mentioned refrigeration apparatus, including the following steps of: S10-S30.

### S10, acquiring monitoring data in real time.

The micro-current value between an electrode and a collector electrode is monitored through a current sensor (e. g., a Hall current sensor integrated into the power supply module), to determine whether there is a risk of arcing (an abnormal increase in current occurs during arcing); the reflectivity of the electrode surface is detected by using an infrared sensor, to assess the degree of dust accumulation (the dust accumulation will lead to a decrease in reflectivity); the thickness of the electrode is measured through an ultrasonic sensor, to determine the electrode wear situation (the wear will lead to the decrease of thickness); the electrode temperature data is collected through a thermistor (e. g., an NTC thermistor) or through a thermal imaging camera.

The airflow velocity and air volume are monitored in real time by using a hot-wire air velocity sensor; and the environmental temperature and humidity data are acquired through the temperature and humidity sensors, to determine whether the insulating properties is decreased due to humidity or the heat dissipation load is increased due to high temperature.

The refrigeration load signal (such as condenser temperature, compressor working state, etc.) is acquired from the main controller of the apparatus main body, and the operating parameters of the power supply modules and the plasma generator 1 are dynamically adjusted in combination with the heat dissipation requirements.

The sensor collects data at a frequency of 10-20 times per second (which may be adjusted according to the sensitivity of parameter variation), and transmits the data to the controller (such as the main control board of ARM chip) through RS-485 bus or CAN bus in real time. The controller performs preprocessing on the raw data by filtering, normalizing, etc., to form an effective monitoring data set, and performs first-order or second-order integration to confirm the variation rate and trend of each parameter.

S20, According to a comparison between real-time monitoring data of a single apparatus and a set threshold, a comparison of a dispersion degree between the real-time monitoring data of different apparatuses and a variation trend of the data, historical operating data and the variation trend of the data, determining whether there is an abnormal situation in a refrigeration apparatus.

S30, If it is determined that an abnormal situation has occurred or is predicted to occur in the refrigeration apparatus according to the monitoring data and variation trend of the data, controlling and adjusting the operating state of plasma generator.

With regard to steps S20 and S30, specifically, the abnormal situation may be classified into multiple levels as follows:

### Risk Level I (Immediate Shutdown Required):

Judgment conditions: arcing between electrodes (the current suddenly increasing to more than 100 mA), the electrode temperature exceeding 120°C (preset safety threshold), and the risk of electric shock to personnel caused by the damage of insulating protective members 161.

Control measures: the controller immediately cuts off the power supply to the high voltage generating module, reduces the voltages between the electrode modules 151 and the collector modules 141 to 0 V, at the same time disconnects the main power supply loop through a relay, sends a shutdown signal to the main controller of the apparatus, and uploads an emergency alarm to the cloud platform through the 4G module (such as "electrode arcing, shutdown").

### Risk Level II (Dynamic Adjustment of Parameters):

Judgment conditions: the air velocity less than 80% of the design value (e. g., the preset air velocity being 5 m/s, the actual measurement being reduced to 4 m/s), the electrode dust accumulation more than 30% (calculated by comparing the reflectivity with historical data), and the environmental humidity more than 85% (possible to trigger creepage).

Control measures: insufficient air velocity or increased environmental humidity: the ionization efficiency is improved by reducing the spacing between the electrode and the collector electrode from 10 mm to 8 mm through the spacing adjustment assembly 18 (e. g., electric push rod) (it is necessary to combine the voltage threshold to avoid arcing), or increasing the output voltage of the high voltage module from 3 kV to 4 kV, or increasing the duty cycle by 2%. Electrode dust accumulation: the automatic cleaning program is activated, a high-frequency alternating current signal (such as 10 kHz, 500 V) is applied to the electrode modules 151 through the controller, the ionic wind produced by corona discharge purges the dust on the electrode surface, and then the reflectivity is re-detected after lasting for 5-10 minutes.

### Risk Level III (Preventive Maintenance Caution):

Judgment conditions: the dispersion trend of monitoring data exceeding 10%, the electrode thickness loss reaching 20% of the initial value (e. g., the initial thickness being 1 mm, the actual measurement being reduced to 0.8 mm), and the cumulative operation time of plasma generator 1 reaching 5000 hours (requiring replacement of wear parts).

Control measures: the controller pushes the maintenance work order to the operation and maintenance personnel through the cloud platform, including "system operating parameters deviate, it is recommended to perform operation and maintenance within 3 days", "electrode wear exceeds the standard, it is recommended to replace the electrode within 3 days" or "the apparatus operates overtime, it is necessary to inspect the insulating components". Operation and maintenance personnel may view specific wear data through the mobile phone APP and remotely confirm the maintenance plan.

In addition, the industry currently widely adopts a traditional heat dissipation structure using fans to dissipate heat from the condenser, where air flow is driven by the fans to bring cold air into contact with the condenser surface and carry away heat, achieving condensation phase change of the cooling medium. However, this traditional heat dissipation structure exhibits significant technical defects in practical applications, specifically manifested in the following two aspects:

On the one hand, the static air layer (boundary layer) results in a low convective heat exchange efficiency. Due to the viscosity of the air molecules, a relatively stationary static air layer (i. e., laminar boundary layer) is naturally formed on the outer surface of the condenser pipeline and the surface of the heat dissipation fins of the condenser. The heat conductive coefficient of the boundary layer is far lower than that of the flowing air, which is equivalent to forming a "heat resistance barrier" on the heat dissipation surface of the condenser, and even if the fans continues to deliver external cold air, most of the cold air is difficult to directly be in contact with the heat dissipation surface of the condenser, and can only exchange heat with the air outside the boundary layer, resulting in that heat cannot be quickly and efficiently transferred from the condenser to the airflow, and finally leading to a significant reduction in convective heat exchange efficiency.

On the other hand, separation of the laminar boundary layer produces vortices, increasing flow resistance and reducing air velocity of the heat dissipation. In the traditional heat dissipation structure, when the airflow driven by the fans flows through the gap between the heat dissipation fins of the condenser, influenced by the structure and shape of the fins and air viscosity, the "laminar separation" phenomenon easily occurs during the flow of the laminar boundary layer along the surface of the fins: the kinetic energy of the air in the boundary layer is not enough to resist the reverse pressure gradient of the main flow of the airflow when the airflow flows over the fins in a certain position, which results in the boundary layer breaking away from the surface of the fins and forming a large area of vortices behind the fins. These vortices not only disrupt the flow path of the main flow of airflow, but also significantly increase the overall flow resistance, and the increase in flow resistance directly leads to a reduction in the effective air velocity actually output by the fan.

In order to improve the above-mentioned problems, in the prior art, optimization is performed by means of increasing the fan power, increasing the number of heat dissipation fins or reducing the fin spacing, etc., but such solutions all have obvious limitations: increasing the fan power will directly lead to the rising of apparatus energy consumption, which is contrary to the current industry development trend of energy saving and consumption reduction; increasing the number of the fins or reducing the spacing will further increase the flow resistance of airflow, and easily lead to the dust accumulation and clogging between the fins, and the heat dissipation efficiency will continue to decline after long-term use. Therefore, how to break through the double constraints of boundary layer and flow resistance in the traditional heat dissipation structure, without significantly increasing the energy consumption and structural complexity, to improve the heat dissipation efficiency of condenser from the root, has become a technical problem to be solved urgently in the heat dissipation field of the refrigeration apparatus.

To this end, the present invention further develops a condenser heat dissipation device adapted to a condenser heat dissipation scenario on the basis of the above-mentioned core ionization structures of the plasma generator, wherein the two are interrelated products formed on the basis of the same inventive concept of plasma ionization producing ionic wind, the core ionization structures of the collector modules 141 and the electrode modules 151 of the plasma generator provide a basic design basis for the electrode modules 151 and the collector modules 141 of the condenser heat dissipation device cooperating with ionized air, and the condenser heat dissipation device is to adapt and integrate the core ionization structures into the condensing modules 4 in a targeted manner, achieving the exclusive application of plasma ionization technology in the heat dissipation field of condenser, the two are interrelated and functionally complementary, serving the high-efficiency heat dissipation requirements of refrigeration apparatus together, as described in detail below.

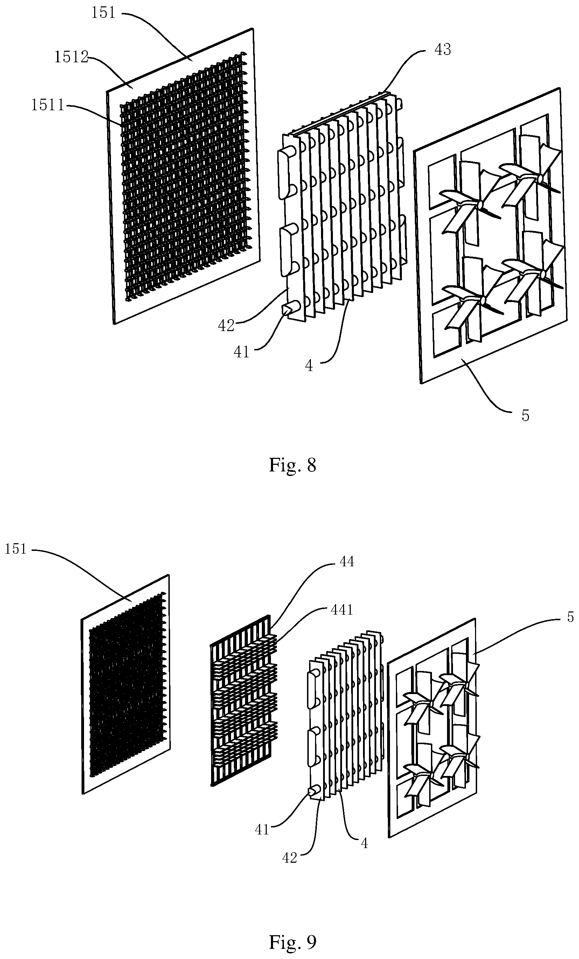

As shown in FIGS. 8 to 11, an embodiment of the present invention provides a condenser heat dissipation device, including electrode modules 151, condensing modules 4 and power supply modules, wherein the electrode modules 151 and the condensing modules 4 are arranged at intervals, the electrode modules 151 cooperate with the condensing modules 4 to ionize air and produce a flowing airflow, the electrode modules 151 include an insulating substrate 1512, a plurality of needle-shaped electrodes 1511 facing the condensing modules 4 are disposed on one side of the insulating substrate 1512 close to the condensing modules 4, the condensing modules 4 are provided with collector modules, negative electrodes of the electrode modules 151 are connected to the needle-shaped electrodes 1511, and positive electrodes of the electrode modules 151 are connected to the collector modules.

In the present invention, by providing that the electrode modules 151 and the condensing modules 4 are arranged at intervals and cooperate to ionize air and produce a flowing airflow, needle-shaped electrodes 1511 facing the condensing modules 4 are disposed on the insulating substrate 1512 of the electrode modules 151, and the positive and negative electrodes of the electrode modules 151 are respectively connected to the collector modules 141 and the needle-shaped electrodes 1511, an ionic wind heat dissipation structure is formed in this way without a mechanical rotating component of a traditional bladed fan, the volume of the heat dissipation structure of the condenser is greatly reduced, the difficulty of the internal layout of the refrigeration apparatus is lowered, and an effective compression of the overall volume of the apparatus is achieved. At the same time, the ionic wind may directly act on the surface of the condensing modules, disrupting the static air boundary layer, reducing laminar separation and vortex production, decreasing airflow resistance and improving the effective heat dissipation air velocity, enhancing the heat dissipation capacity of the condenser from the root without needing to increase fan power or increase the number of heat dissipation fins, etc., solving the problem of heat dissipation without increasing the energy consumption and structural complexity, ultimately achieving miniaturization of the condenser heat dissipation structure, controllable overall volume of the refrigeration apparatus, and significantly improved heat dissipation capacity and heat exchange efficiency.

In addition, it should be emphasized that, by the cooperation of the electrode modules and the condensing modules, the present invention may directly tear the static air layer on the heat dissipation surface of the condenser and entrain the static air layer to the main flow of airflow by using the micro-jet formed by the needle-shaped electrode array to produce extremely strong turbulence and shear force, thus disrupting the boundary layer heat resistance from the root, significantly improving the direct contact efficiency between the cold air and the heat dissipation surface, greatly enhancing the convective heat exchange effect, and effectively avoiding the problems of excessive temperature of the condenser and insufficient condensation of the cooling medium under high load operating conditions; at the same time, ionic wind disturbance can transform the laminar boundary layer into a turbulent boundary layer, by virtue of its stronger kinetic energy, resist the reverse pressure gradient and delay the flow separation, significantly reducing the extremely high proportion of the total flow resistance in the pressure differential resistance, and then improving the heat dissipation air velocity.

It should be noted that in some embodiments, the needle-shaped electrodes 1511 may be replaced by a wire-shaped electrode or other electrode forms.

Specifically, the electrode modules 151 and the condensing modules 4 are arranged at intervals along the flow direction of the airflow inside the refrigeration apparatus (the direction from the air inlet to the air outlet of the refrigeration apparatus), and the interval arrangement needs to satisfy that an effective electric field can be formed between the two modules so as to achieve air ionization, and accidental discharge and short-circuit between the electrode and the collector modules due to an excessively small interval can be avoided; the electrode modules 151 and the condensing modules 4 cooperate under the action of the high voltage electric field provided by the power supply modules to form a directional flowing airflow (i. e., an ionic wind) by ionizing air, and the airflow directly acts on the heat dissipation surface of the condensing modules 4 so as to disrupt the boundary layer, reduce the flow resistance and enhance the heat exchange effect.

The electrode modules 151 include an insulating substrate 1512 and a plurality of needle-shaped electrodes 1511, the insulating substrate 1512 is selected from the material (e. g., a glass fiber epoxy resin plate, an aluminum oxide ceramic plate, etc.) with excellent insulating properties, mechanical strength and temperature resistance, and the outer size thereof is adapted to the size of a heat dissipation area of the condensing modules 4, so as to ensure that the ionic wind formed by the needle-shaped electrodes 1511 may completely cover an effective heat dissipation surface of the condensing modules 4; a plurality of mounting holes distributed in a matrix manner are machined and formed on one side surface (namely, a working surface) of the insulating substrate 1512 close to the condensing modules 4, one needle-shaped electrode 1511 is fixed in each mounting hole, the axes of all the needle-shaped electrodes 1511 are vertical to the working surface of the insulating substrate 1512, and one end facing the condensing modules 4 is provided with a tip end structure, and the tip end structure may enable the electrode end to form a strong electric field, ensuring that air ionization may be achieved under a reasonable high voltage. The needle-shaped electrodes 1511 may be selected from stainless steel with a Teflon coating or plated with zinc, copper, tungsten, titanium alloy, platinum iridium alloy with diamond coating, etc., under some scenarios, the electrode surface may be additionally provided with an anti-corrosion hydrophobic coating (e. g., TiO₂, SiO₂ or composite coating, etc.), so as to avoid the electrode corrosion caused by the adhesion of condensed water inside the refrigeration apparatus or the influence of environmental humidity, and ensure the long-term stable ionization properties of the electrode; in addition, wiring grooves or reserved wiring mounting holes are disposed on the surface of one side of the insulating substrate 1512 away from the condensing modules 4, conductive connecting members (e. g., a copper wire, an etched copper foil, a metal grid 44, etc.) are laid in the grooves or in the holes, and the tail ends (ends away from the tip ends) of all the needle-shaped electrodes 1511 are electrically connected to the conductive connecting members to form uniform electrode leading-out ends for establishing circuit connection with the negative electrodes of the power supply modules.

The condensing modules 4, serving as the heat exchange core and the ion collection carrier, are provided with collector modules.

The power supply modules are high voltage conversion power supplies, the input ends thereof may be adapted to the traditional power supply of the refrigeration apparatus (e. g., alternating current mains power supply, low voltage direct current inside the apparatus, etc.), and the output ends thereof may output the high voltage direct current meeting the requirements of air ionization; the shell of the power supply modules is selected from the material with flame-retardant and insulating properties (e. g., ABS flame-retardant plastic, epoxy plastic, etc.), and rectification, filtering and high voltage conversion circuits are integrated therein so as to achieve the conversion of input electric energy to high voltage direct current; the power supply modules are fixed inside the frame of the refrigeration apparatus by means of bolts or snaps (preferably close to the position of the condensing modules 4, so as to shorten the connection length of wires with the electrode modules 151 and the condensing modules 4, and reduce line losses), the negative electrode output terminals thereof are connected to the leading-out ends of the conductive connecting members of the electrode modules 151 through high voltage-resistant insulating wires, and the positive electrode output terminals are connected to the collector modules of the condensing modules 4 through high voltage-resistant insulating wires of the same specification, so as to form a complete high voltage power supply loop, and ensure that a strong electric field may be stably formed between the electrode modules 151 and the condensing modules 4.

After the refrigeration apparatus is activated, the power supply modules are energized and output a high voltage direct current, so that a strong electric field is formed between the needle-shaped electrodes 1511 (connected to the negative electrodes) of the electrode modules 151 and the heat dissipation fins 42 (connected to the positive electrodes) of the condensing modules 4; under the action of a strong electric field, air molecules at the tip ends of the needle-shaped electrodes 1511 are ionized into positive and negative ions, wherein the negative ions move to the positively charged heat dissipation fins 42 under the action of an electric field force, and collide with neutral air molecules in the movement process, so as to propel the neutral air molecules to flow together to the heat dissipation fins 42, forming a directional ionic wind airflow; the ionic wind airflow directly acts on the surface of the heat dissipation fins 42, and the turbulence and shear force carried thereby can tear the laminar boundary layer on the surface of the heat dissipation fins 42, which is originally stationary, into tiny fragments, and these fragments are entrained into the main flow of airflow to be carried away, so that the metal surface of the heat dissipation fins 42 is directly in contact with the low-temperature airflow, and the heat transfer efficiency is greatly improved; at the same time, the laminar boundary layer on the surface of the heat dissipation fins 42 can be transformed into turbulent boundary layer by the ionic wind airflow, which can enhance the kinetic energy of the airflow to resist the reverse pressure gradient, avoid the separation of the airflow within the gap between the fins and the production of the vortex , effectively reduce the flow resistance of the airflow, and further improve the heat carrying capacity of the airflow.

Thus, the core principle of the present invention of removing the boundary layer on the surface of the condensing modules 4 by ionizing the air to produce the ionic wind and transforming the surface laminar flow into the turbulence so as to reduce the flow resistance can not only significantly improve the heat exchange efficiency but also accelerate the heat exchange rate, and the dual improvement of the heat exchange properties enables the refrigeration apparatus to meet the heat dissipation requirements without relying on large-size heat dissipation fans 5 and large-area heat exchangers, thereby effectively reducing the overall volume of the apparatus, optimizing the internal layout and improving the mounting adaptability without changing the refrigeration power of the refrigeration apparatus, while reducing the apparatus manufacturing cost and space occupancy; or in the case of keeping the volume of refrigeration apparatus unchanged, the refrigeration power can be greatly improved by virtue of the more efficient heat dissipation capacity, so as to enhance the refrigeration properties of apparatus and the applicable scope of the scenarios.

In some embodiments, for example, in the present embodiment, the condensing modules 4 include the condensing pipeline 41 and the plurality of heat dissipation fins 42 arranged at intervals, the cooling medium flows in the condensing pipeline 41, the condensing pipeline 41 passes through the heat dissipation fins 42, and the needle-shaped electrodes 1511 are arranged obliquely with respect to the heat dissipation fins 42.

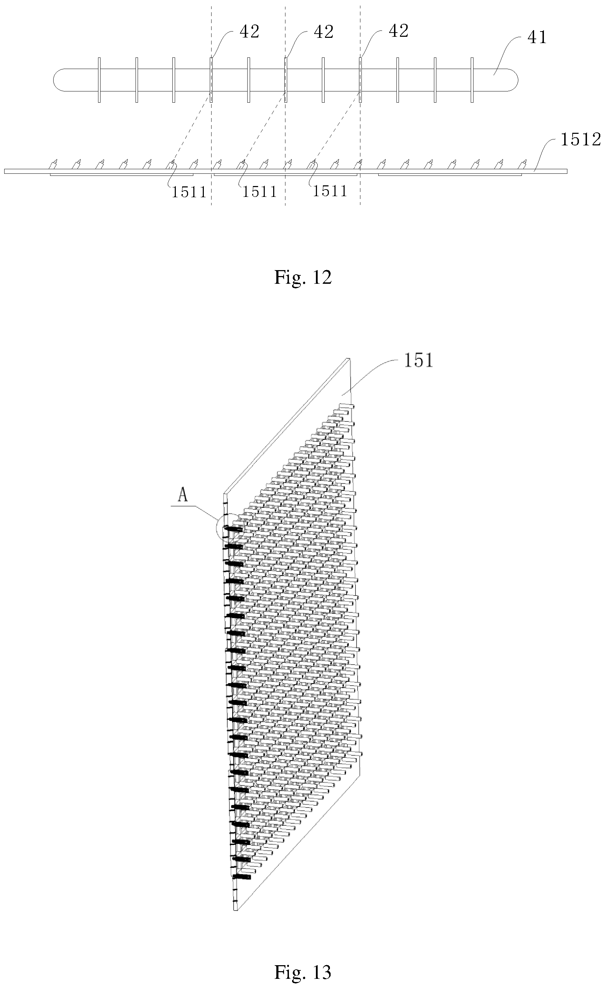

Further, as shown in FIG. 12, in a condenser heat dissipation device, condensing modules 4 include a condensing pipeline 41 for flowing a cooling medium and a plurality of heat dissipation fins 42 arranged at intervals, the condensing pipeline 41 passes through each of the heat dissipation fins 42 so as to achieve heat transfer, an insulating substrate 1512 and the heat dissipation fins 42 are arranged vertically, needle-shaped electrodes 1511 are obliquely mounted on one side of the insulating substrate 1512 close to the heat dissipation fins 42, and the mounting angle thereof forms a preset included angle with the normal line direction of the insulating substrate 1512, so that the tip ends of the needle-shaped electrodes 1511 point obliquely to the surface of the heat dissipation fins 42, thereby achieving an inclined arrangement of the needle-shaped electrodes 1511 with respect to the heat dissipation fins 42; this inclined design enables the micro-jet produced by the needle-shaped electrodes 1511 to precisely impinge on the surface of the heat dissipation fins 42 at an oblique angle; compared with the needle-shaped electrodes 1511 arranged vertically, the oblique jet may form stronger turbulent disturbance and shear force on the surface of the heat dissipation fins 42, and may more easily and quickly tear and disrupt the static air boundary layer attached on the surface of the heat dissipation fins 42, so as to avoid the boundary layer forming a heat resistance barrier; at the same time, can more effectively entrain the boundary layer fragments into the main flow of airflow, further improving the direct contact efficiency between the cold air and the surface of the heat dissipation fins 42, enhancing the convective heat exchange effect, thus further improving the heat dissipation efficiency of the condenser without increasing the energy consumption, and ensuring the complete condensation of the cooling medium under high load operating conditions.

### Embodiment I

In the present embodiment, as shown in FIG. 8, the condensing modules 4 include a condensing pipeline 41, a plurality of heat dissipation fins 42 arranged at intervals and a heat conductive insulating member, a cooling medium flows in the condensing pipeline 41, the condensing pipeline 41 passes through the heat dissipation fins 42, the heat conductive insulating member is disposed between the condensing pipeline 41 and the heat dissipation fins 42, and the heat dissipation fins 42 constitute the collector modules of the condensing modules 4. The condensing modules 4 further include an equipotential bonding plate 43, and the equipotential bonding plate 43 is commonly connected to all the heat dissipation fins 42 in the condensing modules 4.

Specifically, the condensing pipeline 41 is a core carrier through which the cooling medium flows, and may be selected from metal materials having high heat conductivity and being resistant to the corrosion of the cooling medium. According to the cooling medium flow rate and the mounting space requirements of the refrigeration apparatus, the condensing pipeline 41 is processed into a serpentine circuitous structure through a bending process, i. e., multiple horizontal straight pipe sections are provided at intervals along the vertical direction, and the horizontal straight pipe sections are in communication with each other through a U-shaped bent pipe section to form a continuous and closed cooling medium flow channel; two ends of the condensing pipeline 41 respectively extend to the outside of the shell of the refrigeration apparatus, with one end serving as a cooling medium inlet (connected to an exhaust end of the compressor, and inputting a high-temperature and high-pressure gaseous cooling medium) and the other end serving as a cooling medium outlet (connected to a throttling device, and outputting a low-temperature and high-pressure liquid cooling medium), so as to ensure that the cooling medium may completely complete a condensation phase change in the condensing pipeline 41, and continuously release heat.

The heat dissipation fins 42 are key components for heat transfer, and are used for diffusing the heat transferred by the condensing pipeline 41 to a larger area so as to be in full contact with the airflow to achieve heat exchange; the heat dissipation fins 42 may be made of copper or aluminum alloy or steel or titanium, and the heat dissipation fins 42 are in the shape of a sheet or a honeycomb, etc. The length of the heat dissipation fins 42 is adapted to the length of the horizontal straight pipe section of the condensing pipeline 41 to ensure that the fins may completely cover the heat dissipation area in the length direction of the pipeline; a plurality of circular through holes are punched at intervals along the horizontal direction on the heat dissipation fins 42, and the hole diameter of the through holes is adapted to the outer diameter of the condensing pipeline 41, so that the condensing pipeline 41 may pass through all the heat dissipation fins 42 smoothly.

The heat conductive insulating member is provided between the condensing pipeline 41 and the heat dissipation fins 42, the core function thereof is to achieve heat conduction while preventing electrical conduction, and on the one hand, it is necessary to ensure that the heat of the condensing pipeline 41 may be efficiently transferred to the heat dissipation fins 42 so as to avoid influencing heat exchange due to excessive heat resistance; on the other hand, it is necessary to block the electrical conduction between the condensing pipeline 41 and the heat dissipation fins 42, because the heat dissipation fins 42 need to be connected to the high voltage positive electrodes as collector modules, and the condensing pipeline 41 is usually connected to the shell of the refrigeration apparatus (grounded) or other metal components of the cooling medium system. If the two are in direct contact and conducted, high voltage electricity will be introduced into the shell or the cooling medium system, causing potential electrical safety hazards or apparatus failure.

The heat conductive insulating member may be made of heat conductive insulating materials such as aluminum oxide ceramic, aluminum nitride ceramic, beryllium oxide ceramic, heat conductive silicone gaskets, or polyimide-based heat conductive insulating pads. At the same time, the heat conductive silicone greases are applied or heat conductive silicone gaskets are added at the bonding surfaces of the heat conductive insulating member, the condensing pipeline 41 and the heat dissipation fins 42, so as to fill small gaps, further reduce the contact heat resistance, and ensure efficient heat transfer.

In addition, if the voltage applied to the condensing heat dissipation module has no influence on the various components having the potential equivalent to that of the condensing pipeline, it may also be considered that no insulation treatment is performed between the heat dissipation fins and the condensing pipeline.

The equipotential bonding plate 43 is used to keep all the heat dissipation fins 42 at the same potential, so as to avoid the uneven collection of ions due to the potential difference between the fins. If the potentials of the heat dissipation fins 42 are not consistent, the distribution of ionic wind on the surfaces of different fins will be different, and the ionic wind intensity in some areas of the fins is insufficient, so that the boundary layer cannot be effectively disrupted, thus influencing the overall heat dissipation efficiency.

The equipotential bonding plate 43 is made of a long strip-shaped plate made of brass, which has excellent electrical conductive properties, good ductility and welding properties. During assembly, the equipotential bonding plate 43 is arranged along the horizontal straight pipe section of the condensing pipeline 41 and is located at the outermost edge of the condensing pipeline 41, the surface of the equipotential bonding plate 43 is adhered to the end surface of each heat dissipation fin 42, and the equipotential bonding plate 43 and each heat dissipation fin 42 may be welded and fixed by means of a resistance spot welding process to ensure that the two form a firm mechanical connection and a reliable electrical connection; at the same time, a wiring terminal hole may be reserved in the middle portion of the equipotential bonding plate 43 for fixing a high voltage-resistant insulating wire by bolts, and the other end of the wire is connected to the positive electrode output ends of the power supply modules, so that the high voltage positive electrode may be uniformly transferred to all the heat dissipation fins 42 through the equipotential bonding plate 43, ensuring that each fin is at the same positive electrode potential.

With regard to the present embodiment, the heat dissipation fins 42 are directly connected to the positive electrodes of the power supply modules through a potential bonding strip, and as collector modules, a large number of additional components are not introduced, so that the ionic wind can flow over the surface of the heat dissipation fins 42 to the maximum extent, and optimal heat exchange efficiency and flow resistance are achieved.

### Embodiment II

The present embodiment differs from Embodiment I in that the present embodiment is provided with a metal grid 44 as the collector modules instead of using the heat dissipation fins 42 as the collector modules. In the present embodiment, as shown in FIG. 9, the condensing modules 4 include the condensing pipeline 41, the plurality of heat dissipation fins 42 arranged at intervals and a metal grid 44, the cooling medium flows in the condensing pipeline 41, the condensing pipeline 41 passes through the heat dissipation fins 42, the metal grid 44 is disposed within an interval space of the heat dissipation fins 42, and the metal grid 44 constitutes the collector modules of the condensing modules 4. A cross section of load-bearing plates 441 of the metal grid 44 is arranged at an included angle with a cross section of the heat dissipation fins 42.

Specifically, the metal grid 44 serves as collector modules of the condensing modules 4, and is used for cooperating with the electrode modules 151 to form an ionic wind, which is disposed within an interval space of the heat dissipation fins 42 (i. e., in the channel between two adjacent heat dissipation fins 42), and the cross section of the load-bearing plates 441 of the metal grid 44 is arranged at an included angle with the cross section of the fins of the heat dissipation fins 42, and is preferably arranged vertically; and this design may enable the load-bearing plates 441 to form a specific angle with the airflow direction, which neither obstructs the flow of the airflow within the gap between the fins, but maximizes the ion collection area, and ensures that the ionic wind uniformly acts on the surface of the heat dissipation fins 42.

In the present embodiment, the metal grid 44 is made of materials such as copper, aluminum alloy or steel or titanium, and the surface thereof is covered with a nano-hydrophobic insulating coating. The metal grid 44 is composed of a plurality of interval load-bearing plates 441 and an edge frame, the load-bearing plates 441 are long strip-shaped metal strips, the length of which is adapted to the height of the heat dissipation fins 42 (i. e., extending along a direction vertical to the condensing pipeline 41), the edge frame is a rectangular frame, and the two ends of each the load-bearing strip 441 are fixedly connected (e. g., welding or integrally formed) to the edge frame to form an overall grid structure; during assembly, the metal grid 44 is fixed within the interval space of the heat dissipation fins 42 through an insulating support (e. g., a glass fiber epoxy resin support), ensuring that the load-bearing plates 441 are not in contact with the heat dissipation fins 42 or the condensing pipeline 41 (avoiding short circuits), and the metal grid 44 is overall kept at an interval from the electrode modules 151; wiring terminals are provided on an edge frame of the metal grid 44, and are connected to the positive electrodes of the power supply modules through high voltage-resistant insulating wires, so that the metal grid 44 is overall at a positive electrode potential, and negative ions produced by the electrode modules 151 may be effectively collected.

With regard to the present embodiment, the metal grid 44 serves as collector modules, and the heat dissipation fins 42 are electrically uncharged, so that the heat dissipation fins 42 may be in direct contact with the condensing pipeline, improving the heat dissipation efficiency.

### Embodiment III

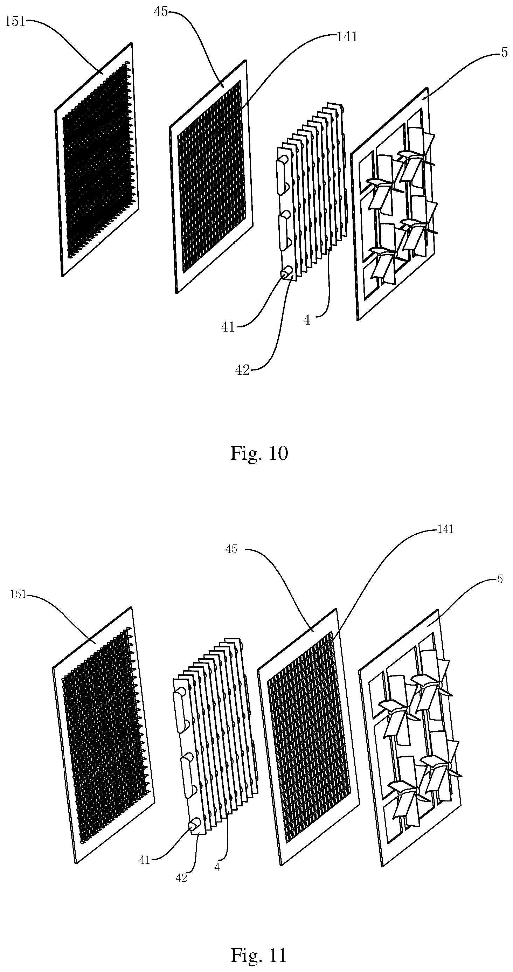

The present embodiment differs from Embodiment II in that the present embodiment is provided with a support frame 45, and collector modules 141 are provided at the support frame 45 instead of using the metal grid 44 as the collector modules 141. In the present embodiment, as shown in FIG. 10, the condensing modules 4 include the condensing pipeline 41, the plurality of heat dissipation fins 42 arranged at intervals and a support frame 45, the cooling medium flows in the condensing pipeline 41, the condensing pipeline 41 passes through the heat dissipation fins 42, and the collector modules 141 are disposed on the support frame 45. The collector modules 141 are arranged at intervals between the insulating substrate 1512 and the heat dissipation fins 42. The support frame 45 is made of an insulating material.

The support frame 45 is a mounting carrier for the collector modules 141, and is made of an insulating material, and may be selected from a glass fiber epoxy resin plate or aluminum oxide ceramic, etc.

The collector modules 141 are provided on the support frame 45, and are arranged at intervals between the insulating substrate 1512 of the electrode modules 151 and the heat dissipation fins 42; the collector modules 141 may adopt a metal mesh or a flat plate flow guiding structure, and are fixed on the support frame 45 by means of a bolt or a snap-fit groove structure, etc.; and the collector modules 141 may be made of materials such as copper, aluminum alloy, steel or titanium. Wiring terminals are disposed in a certain area of the collector modules 141, and are connected to the positive electrodes of the power supply modules through high voltage-resistant insulating wires, so that the collector modules 141 are overall at a positive electrode potential, and negative ions emitted by the electrode modules 151 may be effectively received.

With regard to the present embodiment, the support frame 45 on which the collector modules 141 are mounted is arranged between the insulating substrate 1512 and the heat dissipation fins 42 without influencing the heat transfer between the heat dissipation fins 42 and the condensing pipeline 41.

### Embodiment IV

The present embodiment differs from Embodiment III in that the support frame 45 is located at a different position, and in the present embodiment, as shown in FIG. 11, the collector modules 141 are arranged at intervals on one side of the heat dissipation fins 42 away from the insulating substrate 1512.

With regard to the present embodiment, the arrangement is such that the heat transfer between the heat dissipation fins 42 and the condensing pipeline 41 is not influenced as well.

It should be noted that, in an embodiment of the present invention, the condensing modules 4 are in the form of the condensing pipeline 41 combined with the heat dissipation fins 42, which does not mean that the present invention is only applicable to the condensing modules 4 of this form, and condensing modules 4 of other structures are also equally applicable.

As shown in FIGS. 8 to 11, an embodiment of the present invention also provides a refrigeration apparatus, including fans 5 and the above-mentioned condenser heat dissipation device, the fans 5 are arranged at intervals on one side of the condenser heat dissipation device close to the air outlet of the refrigeration apparatus, i. e., the fans 5 are closer to the air outlet than the condenser heat dissipation device.

An embodiment of the present invention also provides a control method for the operation of a refrigeration apparatus, including the following steps of:

S10, when the refrigeration apparatus is in operation, detecting the rotation speed of the fans 5.

After the refrigeration apparatus is activated, the rotation speed of the fans 5 is controlled by the MCU.

S20, when the real-time rotation speed of the fans 5 is greater than a preset percentage threshold of the rated maximum rotation speed thereof, activating the condenser heat dissipation device while keeping the fans 5 in operation.

S30, when the real-time rotation speed of the fans 5 is less than or equal to a preset percentage threshold of the rated maximum rotation speed thereof, stopping the condenser heat dissipation device while keeping the fans 5 in operation.

With regard to steps S10-S30, after the refrigeration apparatus is activated, the rotation speed of the fans 5 is controlled by the MCU. The preset percentage threshold is 60% of the rated maximum rotation speed (this threshold may be adjusted according to the type and the use scenario of refrigeration apparatus, and is preset through the parameter configuration interface of the main controller). When the real-time rotation speed > the rated maximum rotation speed × 60%, the condenser heat dissipation device is activated while keeping the fans 5 in operation. When the main controller detects that the real-time rotation speed of the fans 5 ≤ the rated maximum rotation speed × 60%, the condenser heat dissipation device is stopped while keeping the fans 5 in operation.

With respect to steps S10-S30, the overall energy consumption may be optimized while effectively controlling the noise of the refrigeration apparatus through such control.

An embodiment of the present invention also provides a refrigeration apparatus, the refrigeration apparatus includes an apparatus main body 2, the plasma generator 1 of the above-mentioned embodiments and the condenser heat dissipation device of the above-mentioned embodiments, and at the same time, fans 5 cooperating with the condenser heat dissipation device are provided to form a coordinated heat dissipation system of plasma enhanced heat dissipation, condenser core heat exchange and auxiliary flow guiding of the fans 5, so as to comprehensively improve the heat dissipation efficiency, operation stability and scenario adaptability of the refrigeration apparatus. The plasma generator 1 is disposed in a gas circulation air duct between the air inlet 21 and the air outlet of the apparatus main body 2, and ionizes air to produce a directional flowing airflow through the synergistic effect of the insulating support, the electromagnetic shielding members 121 and the ionization unit; the airflow can not only directly participate in the air circulation inside the apparatus, but also provide a pre-airflow pretreatment for the condenser heat dissipation device, and disrupt the laminar boundary layer in part of the airflow in advance, so as to lay the foundation for the subsequent heat exchange of the condenser; the condenser heat dissipation device serves as the core heat exchange component of the refrigeration apparatus, the ionic wind produced by the cooperation of the electrode modules 151 and the condensing modules 4 of the condenser heat dissipation device can precisely act on the surfaces of the condensing pipeline 41 and the heat dissipation fins 42, tear the static air boundary layer, reduce the flow resistance, greatly enhance the convective heat exchange effect, and effectively avoid the problem of insufficient condensation of the cooling medium under high load operating conditions; the fans 5 are arranged at intervals on one side of the condenser heat dissipation device close to the air outlet of the refrigeration apparatus, by means of a reasonable spacing design, the airflow circulation around the condenser heat dissipation device can be accelerated by means of the flow guiding function of the fans 5 so as to quickly discharge the heat-exchanged hot air out of the apparatus main body 2, and also can form a synergistic effect with the ionic wind produced by the plasma generator 1 and the condenser heat dissipation device, so as to further improve the overall airflow velocity and heat exchange uniformity. The integrated design of the three makes the refrigeration apparatus not only have the advantages of the plasma generator 1 of being bladeless, low noise and high upper limit of air velocity, but also have the precise heat dissipation capacity of the condenser heat dissipation device for the core heat exchange components; at the same time, the auxiliary flow guiding of the fans 5 is used to optimize the airflow path, which effectively solves the technical problems of the traditional refrigeration apparatus of low heat dissipation efficiency, large noise and unstable high load operating conditions, applicable to various refrigeration scenarios including refrigerators, air conditioners, commercial refrigeration units, and liquid coolers, etc., and especially can meet the use environment of the coexistence of high load operation and low noise requirements.

In some embodiments, for example, in the present embodiment, the refrigeration apparatus further includes a plurality of waterproof sleeves 1513, the plurality of waterproof sleeves 1513 are independent from each other or are connected to each other through a frame to form an integer, each of the plurality of waterproof sleeves 1513 is sheathed on a periphery of each of the needle-shaped electrodes 1511 in a one-to-one correspondence and is connected to the insulating substrate 1512, and vent holes 1514 are disposed at one end of the waterproof sleeves 1513 away from the insulating substrate 1512.

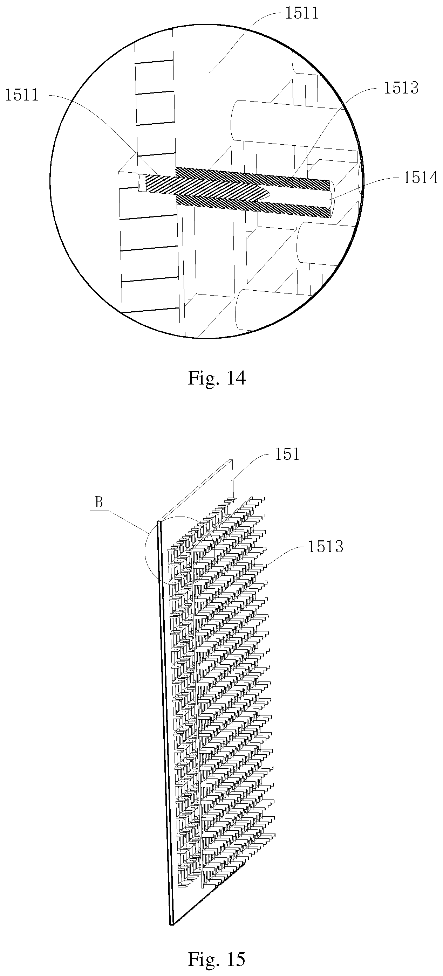

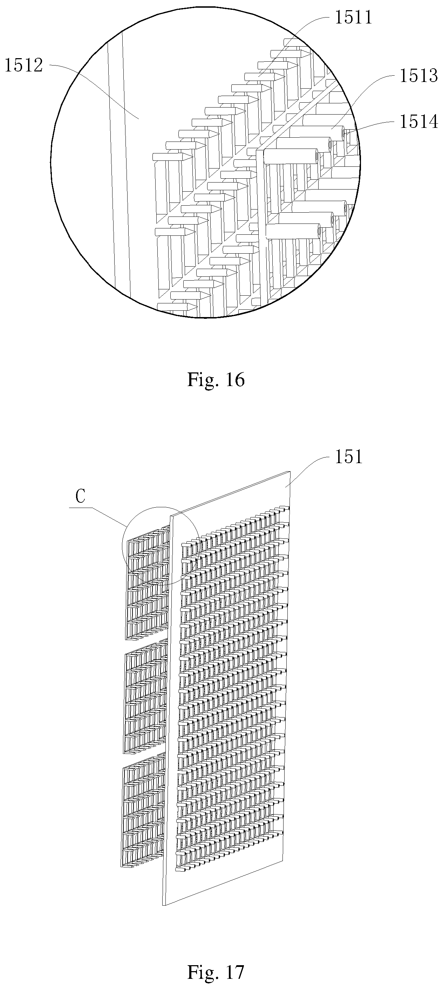

Specifically, the refrigeration apparatus further includes the plurality of waterproof sleeves 1513, the waterproof sleeves 1513 are made of insulating materials, and the function thereof is to solve the risk of insulation failure caused by external rainwater and other conductive liquids in contact with the needle-shaped electrodes 1511 when the refrigeration apparatus is used outdoors or in a humid environment, and to ensure the stable implementation of the ionization function of the electrode modules 151. A plurality of waterproof sleeves 1513 may be arranged in two forms: referring to FIGS. 13 and 14, one is that each of the plurality of waterproof sleeves is independently provided, a single waterproof sleeve 1513 is sheathed on the periphery of each of the needle-shaped electrodes 1511 in a one-to-one correspondence during assembly, and the waterproof sleeves 1513 and the insulating substrate 1512 are fixedly connected through a sealing structure, so as to ensure that no liquid penetrates into a channel at a connection site; referring to FIGS. 15 and 16, the other is that the plurality of waterproof sleeves are connected to each other to form an integrated structure through a frame, during assembly, the overall structure is synchronously sheathed on all the needle-shaped electrodes 1511 so that each of the needle-shaped electrodes 1511 is precisely adapted to a corresponding one of the waterproof sleeves 1513, and the overall structure is sealingly connected to an insulating substrate 1512 so as to ensure a waterproof effect. Vent holes 1514 are disposed at one end of the waterproof sleeves 1513 away from the insulating substrate 1512, the vent holes 1514 not only do not influence the flying-out of particles after the needle-shaped electrodes 1511 ionize air and the formation of an ionic wind, but also can block an external conductive liquid through the main body structure of the waterproof sleeves 1513, so as to achieve both the waterproof protection and the ionization function, and at the same time, cooperating with the insulation treatment of the connection component of the needle-shaped electrodes 1511, the operation reliability of the refrigeration apparatus in a complex humid environment is further improved.

In some embodiments, for example, in the present embodiment, the refrigeration apparatus further includes the plurality of waterproof sleeves 1513, the waterproof sleeves 1513 are integrally formed with the insulating substrate 1512, an axial direction of the waterproof sleeves 1513 is vertical to the insulating substrate 1512, one side of the insulating substrate 1512 facing away from the waterproof sleeves 1513 is provided with electrode insertion holes 1515 communicating with the waterproof sleeves 1513, one end of the waterproof sleeves 1513 away from the insulating substrate 1512 is provided with vent holes 1514; the plurality of needle-shaped electrodes 1511 are connected to each other through the frame to form an integer, and the plurality of needle-shaped electrodes 1511 are inserted into each of the waterproof sleeves 1513 in a one-to-one correspondence from the electrode insertion holes 1515.

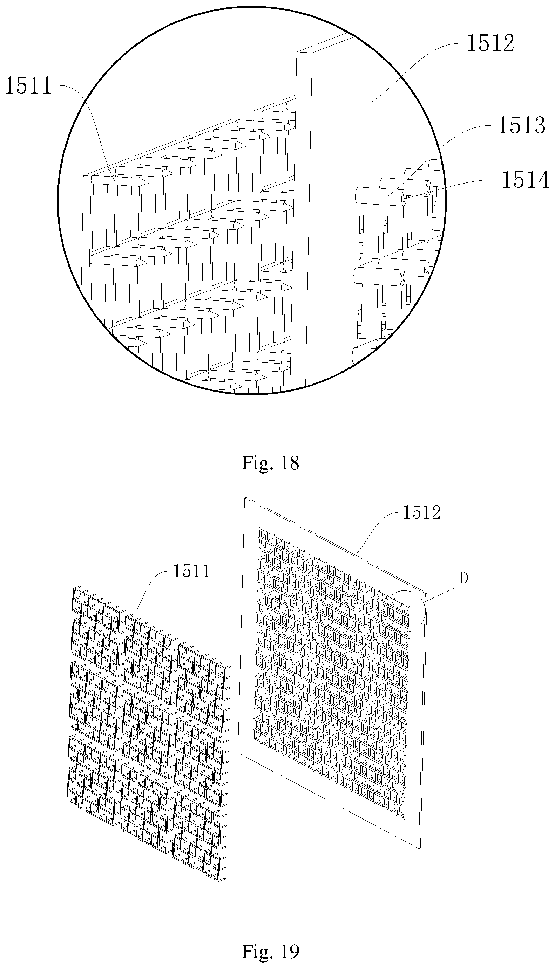

Specifically, referring to FIGS. 17 to 20, the refrigeration apparatus further includes the plurality of waterproof sleeves 1513, the waterproof sleeves 1513 are integrally formed with the insulating substrate 1512; this structural design solves a liquid leakage problem of an assembly gap that may occur in a split-type waterproof structure, and at the same time improves the mechanical strength and assembly efficiency of the overall structure. An axial direction of the waterproof sleeves 1513 is vertical to the insulating substrate 1512, so as to ensure that the protective coverage range of the waterproof sleeves 1513 on the needle-shaped electrodes 1511 is more comprehensive; one side of the insulating substrate 1512 facing away from the waterproof sleeves 1513 is provided with electrode insertion holes 1515 in one-to-one communication with the waterproof sleeve 1513, so as to provide a precise positioning channel for the assembly of the needle-shaped electrodes 1511; the plurality of needle-shaped electrodes 1511 are connected to each other through the frame to form an integer, and during assembly, the overall structure may be synchronously inserted from one side of the electrode insertion holes 1515, so that each of the needle-shaped electrodes 1511 enters each of the waterproof sleeves 1513 in a one-to-one correspondence, and rapid and precise assembly is achieved. Vent holes 1514 are disposed at one end of the waterproof sleeves 1513 away from the insulating substrate 1512, the vent holes 1514 ensure the particles produced by the ionization of the needle-shaped electrodes 1511 to fly out smoothly, ensuring the normal formation of the ionic wind and the implementation of the heat dissipation function; and the integrated structure and sealing design of the waterproof sleeves 1513 can effectively block external rainwater and conductive liquid from being in contact with the needle-shaped electrodes 1511, solving the insulation risk in outdoor use scenarios, and enabling the refrigeration apparatus to adapt to a wider range of environmental operating conditions.

In some embodiments, for example, in the present embodiment, the refrigeration apparatus further includes waterproof louvers 6, the waterproof louvers 6 are disposed on one side of the electrode modules 151 close to the collector modules; or the waterproof louvers 6 are disposed on one side of the electrode modules 151 away from the collector modules; or the waterproof louvers 6 are disposed on both sides of the electrode modules 151.

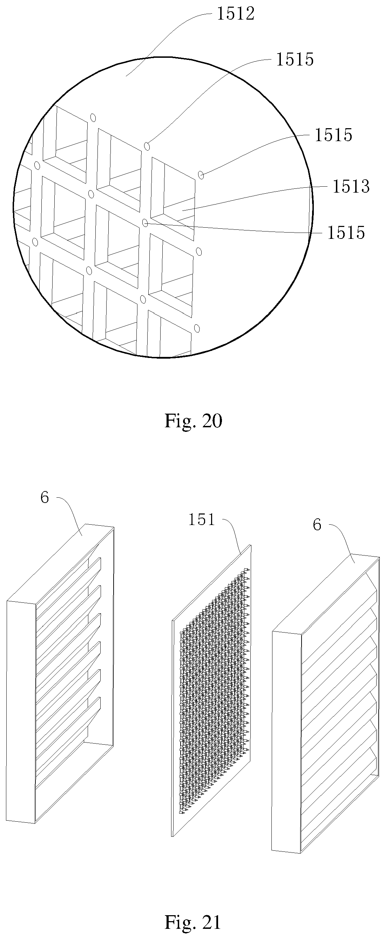

Specifically, referring to FIG. 21, the refrigeration apparatus further includes the waterproof louvers 6, the provision of the waterproof louvers 6 is intended to solve the problem of the insulation failure caused by conductive liquid (e. g., rainwater, splashing liquid) in contact with the needle-shaped electrodes 1511 when the refrigeration apparatus is used in the external environment with low protection level, and at the same time ensure air circulation so as not to influence the generation of ionic wind and the heat dissipation effect. The mounting position of the waterproof louvers 6 may be flexibly adjusted according to the splashing direction of the conductive liquid in the actual use scenario; when the conductive liquid may splash from one side of collector modules, the waterproof louvers 6 are disposed on one side of the electrode modules 151 close to the collector modules; when the conductive liquid may splash from one side away from the collector modules, the waterproof louvers 6 are disposed on one side of the electrode modules 151 away from the collector modules; when there is a risk of conductive liquid splashing from multiple directions, the waterproof louvers 6 are disposed on both sides of the electrode modules 151. Through its own structural characteristics, the waterproof louvers 6 effectively block the conductive liquid without hindering the air circulation and ion transfer, avoid the needle-shaped electrodes 1511 being in contact with the conductive liquid, ensure the stability of the insulating properties and ionization function of the electrode modules 151, and thus ensure the reliable operation of the refrigeration apparatus in the complex external environment.

In addition, the surface of the wire or the etched copper foil or the metal grid 44 connecting a plurality of needle-shaped electrodes 1511 and the connecting position may be insulated by means of an insulating skin, an insulating coating or an insulating adhesive, etc.

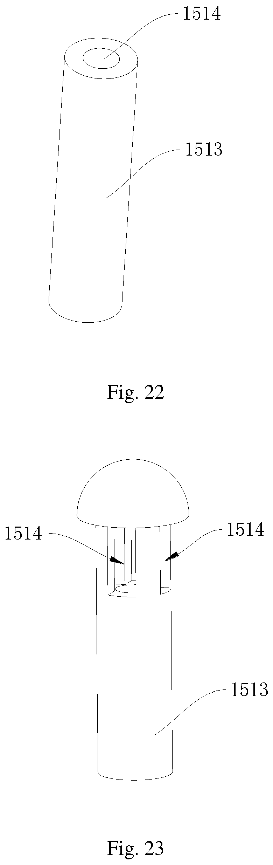

In some embodiments, for example, in the present embodiment, referring to FIGS. 22 and 23, the waterproof sleeves 1513 may adopt various different structures. For example, the waterproof sleeves 1513 may be designed in a cylindrical structure to adapt to different arrangement forms of needle-shaped electrodes 1511 and the air outlet direction of the refrigeration apparatus, so as to ensure the balance between waterproof protection and ionization function. When the needle-shaped electrodes 1511 are arranged horizontally (corresponding to a scenario of a side airflow in a refrigeration apparatus), the vent holes 1514 are provided at end portions of the cylindrical waterproof sleeves 1513, and the orientation of the vent holes 1514 is consistent with the air outlet direction of the refrigeration apparatus, which can not only enable particles produced by ionization of the needle-shaped electrodes 1511 to smoothly fly out from the vent holes 1514 provided at the end portions, to form a directional ionic wind so as to satisfy heat dissipation requirements, but also block a conductive liquid splashing from the side through a cylindrical side wall structure so as to avoid rainwater and the like being in contact with the needle-shaped electrodes 1511. When the needle-shaped electrodes 1511 are arranged vertically (corresponding to a scenario of an upward airflow in a refrigeration apparatus), the vent holes 1514 of the cylindrical waterproof sleeves 1513 are provided on the side wall, and a plurality of vent holes 1514 are arranged at intervals along the circumference of the waterproof sleeves 1513; this design may avoid the end portions facing upwards being directly in contact with rainwater, the diffusion and flying-out of the ionized particles are achieved through the vent holes 1514 on the side wall, and at the same time, the vent holes 1514 distributed circumferentially can ensure the uniform output of the ionic wind without influencing the heat dissipation effect, so as to enable the waterproof sleeves 1513 to adapt to different apparatus structures and use scenarios and improve the applicability of the refrigeration apparatus in an outdoor complex environment.

It should be noted that the plasma generator, the condenser heat dissipation device and the refrigeration apparatus of the present invention form a closely related whole around the core technical concept of producing ionic wind for enhanced heat dissipation based on plasma ionization. As the core function module, the plasma generator provides stable and controllable ionic wind generating function. Through the co-design of insulating support, electromagnetic shielding members and ionization unit, the plasma generator solves the key problems of electromagnetic interference, mounting and positioning in the process of ionic wind generation, and is the basis for achieving high-efficiency heat dissipation. Condenser heat dissipation device is an exclusive application form of plasma generator in the core heat exchange scenario of refrigeration apparatus, the condenser heat dissipation device organically integrates the ionization unit of plasma generator with the condensing pipeline of condensing modules and the heat dissipation fins, achieves the precise and enhanced heat exchange with regard to the pain points of heat dissipation of condenser, such as high heat resistance and flow resistance of boundary layer, and is a functional carrier for connecting plasma generator and refrigeration apparatus. As an overall application apparatus, the refrigeration apparatus integrates the above-mentioned plasma generator and condenser heat dissipation device, and forms a complete heat dissipation system together with auxiliary components such as fans. The ionic wind provided by the plasma generator cooperates with the heat exchange structure of the condenser heat dissipation device, and in combination with the flow guiding optimization of the fan, the efficient and stable heat dissipation of the refrigeration apparatus is achieved together. The three all have the same specific technical feature that collector modules and electrode modules are arranged at intervals, and the collector modules cooperate with the electrode modules to ionize air and produce a flowing airflow. Moreover, the three respectively correspond to the hierarchical relationship of the core module, the exclusive subsystem and the overall apparatus, complement and cooperate with each other to jointly solve the technical problems such as low heat dissipation efficiency and unstable high-load operating conditions of the traditional refrigeration apparatus, and constitute the associated technical solutions under the same inventive concept to ensure the unity and integrity of the overall technical solutions.

## Claims

1. A plasma generator, **characterized by** comprising an insulating support, electromagnetic shielding members and an ionization unit disposed on the insulating support, wherein the electromagnetic shielding members and the insulating support are combined to form an electromagnetic shielding cavity, the ionization unit is disposed in the electromagnetic shielding cavity, the ionization unit comprises at least one set of collector modules and electrode modules arranged oppositely and at intervals, and the collector modules cooperate with the electrode modules to ionize air and produce a flowing airflow.

2. The plasma generator according to claim 1, **characterized in that** the insulating support comprises a main frame, a first outer frame and a first inner frame, the first outer frame is disposed outside the main frame, the first inner frame is disposed inside the main frame, the first outer frame and the first inner frame are both provided with the electromagnetic shielding members, and the collector modules and the electrode modules are disposed between the first outer frame and the first inner frame.

3. The plasma generator according to claim 2, **characterized in that** the insulating support further comprises a first mounting frame and a second mounting frame, the first mounting frame and the second mounting frame are disposed between the main frame and the first inner frame, and the first mounting frame is disposed close to the main frame, the collector modules are disposed in the first mounting frame, and the electrode modules are disposed in the second mounting frame.

4. The plasma generator according to claim 1, **characterized in that** the electrode modules comprise an insulating substrate, a plurality of needle-shaped electrodes are disposed on one side of the insulating substrate close to the collector modules, and the collector modules comprise a collector electrode substrate, a plurality of metal meshes are disposed on the collector electrode substrate.

5. The plasma generator according to claim 1, **characterized by** further comprising a spacing adjustment assembly, wherein the spacing adjustment assembly is used for adjusting spacings between the collector modules and the electrode modules, the spacing adjustment assembly comprises a driving member, and the driving member is used for driving one of the collector modules and the electrode modules to move towards or away from the other.

6. The plasma generator according to claim 2, **characterized by** further comprising insulating protective members, wherein the insulating support further comprises a second outer frame and a second inner frame, the second outer frame is located outside the first outer frame, the second inner frame is located inside the first inner frame, and the second outer frame and the second inner frame are both provided with the insulating protective members.

7. A condenser heat dissipation device, **characterized by** comprising electrode modules, condensing modules and power supply modules, wherein the electrode modules and the condensing modules are arranged at intervals, the electrode modules cooperate with the condensing modules to ionize air and produce a flowing airflow, the electrode modules comprise an insulating substrate, a plurality of needle-shaped electrodes facing the condensing modules are disposed on one side of the insulating substrate close to the condensing modules, the condensing modules are provided with collector modules, negative electrodes of the electrode modules are connected to the needle-shaped electrodes, and positive electrodes of the electrode modules are connected to the collector modules.

8. The condenser heat dissipation device according to claim 7, **characterized in that** the condensing modules comprise a condensing pipeline, a plurality of heat dissipation fins arranged at intervals and a plurality of heat conductive insulating member arranged at intervals, a cooling medium flows in the condensing pipeline, the condensing pipeline passes through the heat dissipation fins, the heat conductive insulating member is disposed between the condensing pipeline and the heat dissipation fins, the heat dissipation fins constitute the collector modules of the condensing modules; the condensing modules further comprise an equipotential bonding plate, and the equipotential bonding plate is commonly connected to all the heat dissipation fins in the condensing modules.

9. The condenser heat dissipation device according to claim 7, **characterized in that** the condensing modules comprise the condensing pipeline, the plurality of heat dissipation fins arranged at intervals and a metal grid, the cooling medium flows in the condensing pipeline, the condensing pipeline passes through the heat dissipation fins, the metal grid is disposed within an interval space of the heat dissipation fins, the metal grid constitutes the collector modules of the condensing modules; and a cross section of load-bearing plates of the metal grid is arranged at an included angle with a cross section of the heat dissipation fins.

10. The condenser heat dissipation device according to claim 7, **characterized in that** the condensing modules comprise the condensing pipeline, the plurality of heat dissipation fins arranged at intervals and a support frame, the cooling medium flows in the condensing pipeline, the condensing pipeline passes through the heat dissipation fins, the collector modules are disposed on the support frame; the collector modules are arranged at intervals between the insulating substrate and the heat dissipation fins, or the collector modules are arranged at intervals on one side of the heat dissipation fins away from the insulating substrate.

11. The condenser heat dissipation device according to claim 7, **characterized in that** the condensing modules comprise the condensing pipeline and the plurality of heat dissipation fins arranged at intervals, the cooling medium flows in the condensing pipeline, the condensing pipeline passes through the heat dissipation fins, and the needle-shaped electrodes are arranged obliquely with respect to the heat dissipation fins.

12. A refrigeration apparatus, **characterized in that** the refrigeration apparatus comprises an apparatus main body and the plasma generator according to any one of claims 1-6, the plasma generator is disposed in a gas circulation air duct between an air inlet and an air outlet of the apparatus main body, the plasma generator causes the air in the gas circulation air duct to flow from the air inlet of the apparatus main body to the air outlet of the apparatus main body; and/or,
the refrigeration apparatus comprises fans and the condenser heat dissipation device according to any one of claims 7-11, and the fans are arranged at intervals on one side of the condenser heat dissipation device close to the air outlet of the refrigeration apparatus.

13. The refrigeration apparatus according to claim 12, **characterized by** further comprising a plurality of waterproof sleeves, wherein the plurality of waterproof sleeves are independent from each other or are connected to each other through a frame to form an integer, each of the plurality of waterproof sleeves is sheathed on a periphery of each of the needle-shaped electrodes in a one-to-one correspondence and is connected to the insulating substrate, and vent holes are disposed at ends of the waterproof sleeves away from the insulating substrate.

14. The refrigeration apparatus according to claim 12, **characterized by** further comprising the plurality of waterproof sleeves, wherein the waterproof sleeves are integrally formed with the insulating substrate, an axial direction of the waterproof sleeves is vertical to the insulating substrate, one side of the insulating substrate facing away from the waterproof sleeves is provided with electrode insertion holes communicating with the waterproof sleeves, the vent holes are disposed at the ends of the waterproof sleeves away from the insulating substrate; the plurality of needle-shaped electrodes are connected to each other through the frame to form an integer, and each of the plurality of needle-shaped electrodes is inserted into each of the waterproof sleeves in a one-to-one correspondence from the electrode insertion holes.

15. The refrigeration apparatus according to claim 12, **characterized by** further comprising waterproof louvers, wherein the waterproof louvers are disposed on one side of the electrode modules close to the collector modules; or the waterproof louvers are disposed on one side of the electrode modules away from the collector modules; or the waterproof louvers are disposed on both sides of the electrode modules.
